Europäisches Patentamt

European Patent Office

Office européen des brevets

(11) Veröffentlichungsnummer : **0 095 517**
**B1**

(19)

# (12) EUROPÄISCHE PATENTSCHRIFT

(45) Veröffentlichungstag der Patentschrift :
21.11.85

(51) Int. Cl.⁴ : **G 01 R 31/26, G 01 B 11/24, G 06 K 9/56**

(21) Anmeldenummer : 82104731.3

(22) Anmeldetag : 28.05.82

(54) Verfahren und Einrichtung zur automatischen optischen Inspektion.

(43) Veröffentlichungstag der Anmeldung :
07.12.83 Patentblatt 83/49

(45) Bekanntmachung des Hinweises auf die Patenterteilung : 21.11.85 Patentblatt 85/47

(84) Benannte Vertragsstaaten :
DE FR GB

(56) Entgegenhaltungen :
EP-A- 0 023 574
DE-A- 2 700 252
DE-B- 2 601 522
ELECTRONIC ENGINEERING, Band 45, Nr. 547, September 1973 R. STEELE et al.: "An automatic digital trace encoder for polaroid photographs"

(73) Patentinhaber : IBM DEUTSCHLAND GMBH
Pascalstrasse 100
D-7000 Stuttgart 80 (DE)
DE
International Business Machines Corporation
Old Orchard Road
Armonk, N.Y. 10504 (US)
FR GB

(72) Erfinder : Baier, Heinz, Ing. grad.
Schwenninger Strasse 14
D-7032 Sindelfingen 6 (DE)
Erfinder : Köpp, Peter, Dipl.-Informatiker
Friedrich-Ebert-Strasse 5
D-7030 Böblingen (DE)
Erfinder : Pfeffer, Erwin, Ing. grad.
Teckstrasse 12
D-7031 Holzgerlingen (DE)
Erfinder : Reimann, Hans-Peter, Dipl.-Ing.
Wilhelm-Haspel-Strasse 16
D-7032 Sindelfingen (DE)
Erfinder : Rösch, Hans, Dr. Dipl.-Ing.
Römersteinstrasse 4
D-7411 Reutlingen-Sondelfingen (DE)
Erfinder : Schneiderhan, Martin
Ebinger Weg 23
D-7000 Stuttgart 80 (DE)

(74) Vertreter : Teufel, Fritz, Dipl.-Phys.
IBM Deutschland GmbH. Europäische Patentdienste
Postfach 265
D-8000 München 22 (DE)

**Beschreibung**

Die Erfindung betrifft ein Verfahren zur automatischen optischen Inspektion nach dem Oberbegriff des Hauptanspruchs und eine Einrichtung zur Durchführung des Verfahrens.

Auf vielen Gebieten der Technik, insbesondere bei Fertigungsverfahren, ist man seit langem bemüht, die visuelle Überwachung oder Prüfung von Gegenständen durch automatisierte Verfahren zu ersetzen, um die Auswertung schneller, genauer und mit höherer Sicherheit durchführen zu können. Als mögliche Anwendungsgebiete derartiger automatisierter Einrichtungen können die Handhabung von Teilen (z. B. mit Robotern), die Mustererkennung oder die Qualitätsprüfung genannt werden.

Ein besonders dringendes Problem stellt die visuelle Prüfung von komplexen, im wesentlichen zweidimensionalen Mustern dar, wie sie auf Leiterplatten oder in photolithographischen Masken auftreten. Fehler in derartigen Produkten sollten zu hundert Prozent erkannt werden, da sie sonst zu Folgefehlern in späteren Produktionsschritten führen können, die sehr hohe Kosten verursachen. Die geringen Abmessungen der Musterelemente und die hohe Dichte der Muster verlangen bei der Prüfung eine hohe Ortsauflösung mit der Folge eines hohen Zeitaufwandes für jeden Prüfvorgang.

Die bei der Prüfung von Leiterplatten häufig verwendeten elektrischen Methoden (Durchgangsprüfung) zeigen nicht alle Schwachstellen einer Leiterplatte auf ; beispielsweise kann eine Querschnittsverdünnung eines Leiterzugs bei der elektrischen Prüfung unbemerkt bleiben, sich aber im späteren Betrieb infolge der höheren Stromdichte an dieser Stelle weiter verändern und zu einer Leiterunterbrechung führen. Außerdem ist die elektrische Kontaktierung bei sehr dichten Leiterbahnmustern sehr schwierig. Die visuelle Prüfung ist aus den genannten Gründen unerläßlich, verlangt aber einen nicht mehr tragbaren Personalaufwand und ist naturgemäß fehleranfällig.

Die bisher bekannt gewordenen Vorschläge für eine automatisierte optische Beschaffenheitskontrolle sind in dem Artikel von T. H. Ricker und J. Schürmann « Mask and Pattern Inspection Systems », NTG Fachberichte, Band 60 (1977), Seite 229 beschrieben ; sie machen entweder von einem optischen System Gebrauch, das durch räumliche Filterung die fehlerfreien Musterbestandteile aussondert oder von einer optischen Einrichtung, die einen Punkt-für-Punkt Vergleich des zu prüfenden Musters mit einer fehlerfreien Vorlage durchführt oder von den Prinzipien der digitalen Bildverarbeitung. Die ersten beiden vorgeschlagenen Wege erfordern einen relativ hohen optischen Aufwand, eine hohe Justiergenauigkeit und sind wenig flexibel. Bei den digitalen Bildverarbeitungsverfahren führt die Bildabtastung zu großen Datenmengen, deren Verarbeitung einen großen Zeitaufwand oder umfangreiche Schaltungen erfordert.

Eine Einrichtung zur automatisierten visuellen Inspektion (oder allgemeiner zur digitalen Bildverarbeitung), wie sie beispielsweise in den Artikeln G. B. Porter 3, « Visual Inspection System Design », Computer, May 1980, Seite 40 oder in dem Buch L. Bolc und Z. Kulpa « Digital Image Processing System » Berlin/Heidelberg/New York 1981, Seite 6 beschrieben ist, besteht aus einem opto-elektronischen Wandler, beispielsweise einer Fernsehkamera, der ein Analog/Digital-Wandler nachgeschaltet ist, mit dem die den Grauwerten der Bildpunkte entsprechenden Binärzahlen in einen Bildspeicher abgegeben werden. Für diesen Bildspeicher ist eine beträchtliche Kapazität erforderlich, die bei der üblichen Größe der abgetasteten Bildausschnitte von einigen hundert Zeilen zu je einigen hundert Bildpunkten in der Größenordnung von einigen hundert Kilobyte liegt. Die gespeicherten binären Bilder werden mit Hilfe von Programmen, die in einem Universalrechner ablaufen und/oder speziellen, für die Bildauswertung vorgesehenen Schaltungen verarbeitet und das Ergebnis zur weiteren Verarbeitung in den Speicher zurückgeschrieben ; über einen Digital/Analog-Wandler wird das verarbeitete Bild auf einem Monitor sichtbar gemacht.

In der deutschen Auslegeschrift 27 26 746 ist eine Einrichtung zur Fehlerkontrolle des Oberflächenmusters eines Objekts beschrieben, bei dem das vom Objekt erzeugte Binärbild mit einem elektronisch gespeicherten fehlerfreien Muster verglichen wird. Der Musterspeicher hoher Kapazität ist kostenaufwendig. Eine Einrichtung zur optischen Beschaffenheitsprüfung von Leiterplatten wird außerdem in der europäischen Patentanmeldung 23574 beschrieben, bei der nur jeweils kleine Ausschnitte aus einem Muster daraufhin geprüft werden, ob die für das Muster festgelegten Grundregeln eingehalten sind, beispielsweise die Breite der Leiterzüge und deren gegenseitiger Abstand. Bei diesem Prüfverfahren kann nicht festgestellt werden, ob ganze Teile des Musters weggefallen sind.

Ein wesentlicher Nachteil aller bisher bekannt gewordenen Inspektionssysteme auf digitaler Grundlage besteht darin, daß sie bei wirtschaftlich tragbarem Schaltungsaufwand, beispielsweise der Verwendung eines Mikroprozessors für die Bildanalyse, zu lange Verarbeitungszeiten für die Prüfung eines Musters oder eines Musterausschnitts benötigen. Bei einer Massenproduktion, beispielsweise von Leiterplatten, wird gefordert, daß die Prüfung eines Musterausschnitts, der beispielsweise von einer Fernsehkamera in einen Bildspeicher geschrieben wird, innerhalb von einigen hundert Millisekunden erfolgen kann, um so die Verarbeitungsgeschwindigkeit der Geschwindigkeit anzupassen, mit der das zu prüfende Muster abgetastet werden kann. Die Abtastung erfolgt dabei mit hoher Vergrößerung, so daß noch Bildpunkte von einigen μm Durchmesser erkannt werden können. Bei der geforderten hohen Auflösung ist ein weiterer Nachteil der heute üblichen Systeme, die Binärbilder verarbeiten, darin zu sehen, daß beim Übergang von einem Grauwertbild auf das Binärbild ein Digitalisierungsfehler in der Position der Bildpunkte auftritt, die im Gebiet des Übergangs von einem hellen zu einem dunklen Gebiet liegen.

Diese Nachteile treten auch bei dem Verfahren zum Prüfen definierter Strukturen auf, das aus der DE-OS 27 00 252 bekannt ist. Dort wird eine binäre (Hell-Dunkel-) Darstellung des Prüflings in einem Digital-Speicher erzeugt und in mehreren Schritten verarbeitet, wobei zuerst die für die Struktur wesentliche Information (z. B. Kanten) ermittelt wird. In jedem dieser Verarbeitungsschritte muß jeder Bildpunkt im Speicher adressiert werden, um die notwendigen lokalen Operationen durchzuführen, beispielsweise die Feststellung der Kanten. Diese Operationen benötigen viel Zeit.

Die vorliegende Erfindung stellt sich daher die Aufgabe, ein Verfahren und eine Einrichtung zur automatischen optischen Inspektion der eingangs genannten Art anzugeben, die mit vertretbarem Schaltungsaufwand eine optische Beschaffenheitsprüfung von zweidimensionalen Mustern, insbesondere Leiterbahnplatten, mit hoher Geschwindigkeit und großer Auflösung ermöglicht und leicht an verschiedene Mustervorlagen angepaßt werden kann.

Diese Aufgabe wird durch die in den Ansprüchen 1 und 5 gekennzeichnete Erfindung gelöst; Ausgestaltungen der Erfindung sind in den Unteransprüchen gekennzeichnet.

Die Erfindung schlägt ein zweistufiges Prüfverfahren für ein aus dem Prüfling abgeleitetes, digitalisiertes und abgespeichertes Grauwert-Bild vor, bei dem in einem ersten digitalen Verarbeitungsschritt alle diejenigen Bereiche des Bildspeichers geprüft und markiert werden, die fehlerfreie Kantenelemente enthalten und bei dem in einem zweiten Schritt alle nicht markierten Bereiche des Bildspeichers mit hoher Geschwindigkeit auf das Vorliegen erlaubter Graustufen abgefragt werden. Die Einrichtung zur Durchführung des Verfahrens verwendet zur Bildspeicherung einen Digitalspeicher, bei dem ein Bit des Digitalworts, das den Grauwert des zugeordneten Bildpunkts anzeigt, dazu verwendet wird, als Markierungsbit für die schon erfolgte Prüfung dieses Bildpunktes zu dienen.

Ausführungsbeispiele der Erfindung werden nun anhand von Zeichnungen näher erläutert. Es zeigen:

Figur 1 einen (vergrößerten) Ausschnitt aus einer Leiterplatte mit typischen Musterelementen und Beispielen für Abtastspuren, die beim Verfahren nach der vorliegenden Erfindung verwendet werden;

Figur 2 einen (stärker vergrößerten) Ausschnitt einer Kante eines Leiterzuges und eine Abtastspur für eine Kante zur Erläuterung des Verfahrens zur Feststellung der Kantenlage durch Differenzbildung von Summen der Grauwerte in Bildpunkten senkrecht zur Kante;

Figur 3 die bei der Differenzbildung von Grauwertsummen verwendeten Bildelemente bei schräg liegenden Kanten von Leiterzügen;

Figur 4 das Blockschaltbild der Einrichtung zur automatischen optischen Inspektion nach der vorliegenden Erfindung;

Figur 5 das Format eines Eintrags im Bildspeicher für den Grauwert eines Bildpunkts mit Markierungsbit;

Figur 6 eine Schaltung zum Setzen des Markierungsbits;

Figur 7 eine Schaltung zur schnellen Errechnung von Speicheradressen in der Einrichtung nach Fig. 4;

Figuren 8A, B Blockschaltbilder der Verarbeitungseinheit in der Einrichtung nach Fig. 4;

Figuren 9A, B das Kantenprofil einer Leiterbahn nach Abtastung und Normalisierung zur Erläuterung einer Betriebsweise der Verarbeitungseinheit nach Fig. 8.

Die vorliegende Erfindung geht von der Erkenntnis aus, daß in vielen Arten von Bildern oder graphischen Vorlagen der Informationsgehalt durch wenige Bildelemente bestimmt wird. Dies trifft beispielsweise für Leiterplatten und photolithographische Masken zu, in denen hauptsächlich die Kantenübergänge zwischen hellen Gebieten (z. B. Leiterzügen) und dunklen Gebieten (z. B. Grundplatte aus Isoliermaterial) von Interesse sind. Bei ordnungsgemäßer Struktur einer Leiterplatte müssen die Kanten gewisse visuell erkennbare Bedingungen erfüllen; so dürfen die Kanten nur in gewissen Richtungen verlaufen, sie dürfen nicht unterbrochen sein und müssen innerhalb gewisser gegenseitiger Mindest- oder Höchstabstände liegen (Leiterzugbreite bzw. Minimalabstand zweier Leiterzüge). Die Anzahl der in einem Muster vorkommenden geometrischen Teilfiguren ist außerdem in den meisten Fällen beschränkt.

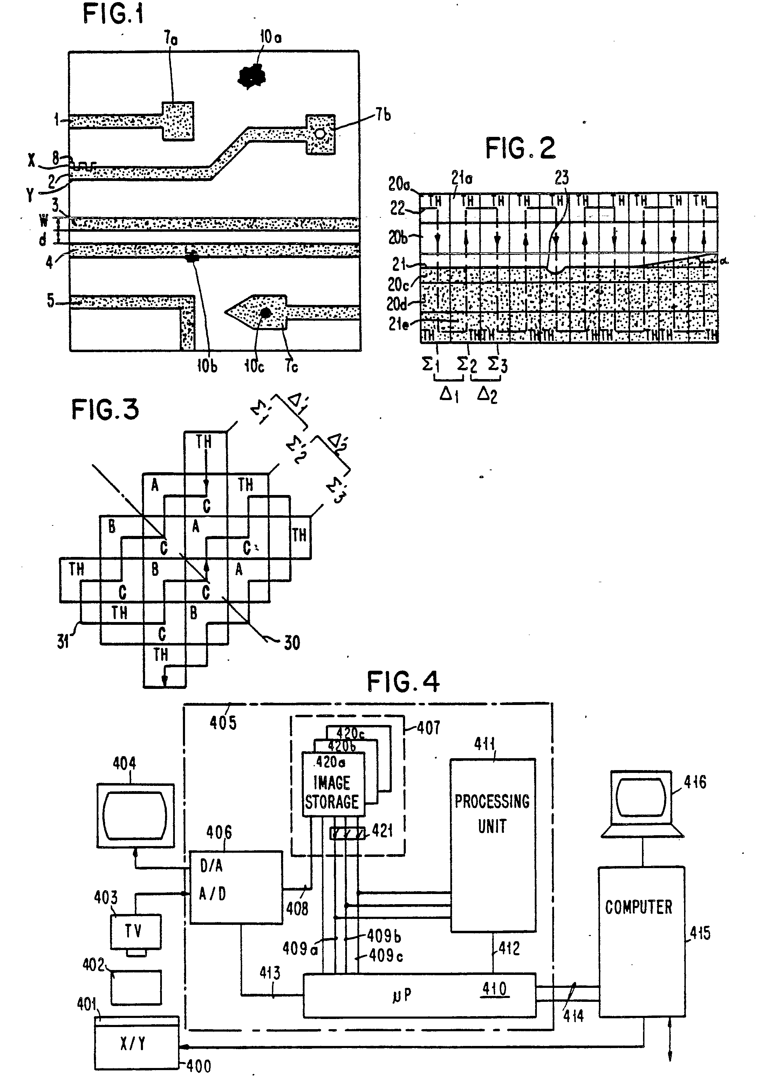

In Fig. 1 ist ein vergrößerter Ausschnitt 1 aus einer Leiterplatte dargestellt, der einige typischerweise vorkommende Musterelemente enthält. Die punktiert dargestellten Leiterzüge mit einer Nennbreite w und einem Mindestabstand d verlaufen geradlinig (3, 4), knicken unter einem Winkel von 45 oder 90° ab (2 bzw. 5) und enden niemals unvermittelt, sondern werden jeweils durch Lötaugen verschiedener Gestalt abgeschlossen (7a bis 7c). Fehlerhafte Gebiete im Leiterzug können entweder auf der isolierenden Grundplatte liegen (10a), auf einer Kante (10b) oder innerhalb eines Leiterzugs (10c). Die Prüfung eines derartigen Leiterplattenausschnitts kann sich auf mehrere Aspekte beziehen:

auf die lokale Einhaltung von Nennbreite w und Mindestabstand d der Leiterzüge

auf fehlerhafte Gebiete der Isolierplatte (z. B. 10a) oder Einschlüsse innerhalb von Leiterzügen (z. B. 10c)

auf das Vorhandensein und die relative Anordnung von Leiterzügen oder Musterelementen entsprechend der zugrundeliegenden Konstruktionsvorschrift.

Bei der letztgenannten Prüfung müssen die zugrundeliegenden Konstruktionsdaten geeignet aufbereitet und gespeichert und mit repräsentativen Werten des tatsächlich vorliegenden Musters verglichen werden. Die beiden anderen Parameter können auch ohne Rückgriff auf Konstruktionsdaten

3

in jeder beliebigen lokalen Umgebung des Musters geprüft werden.

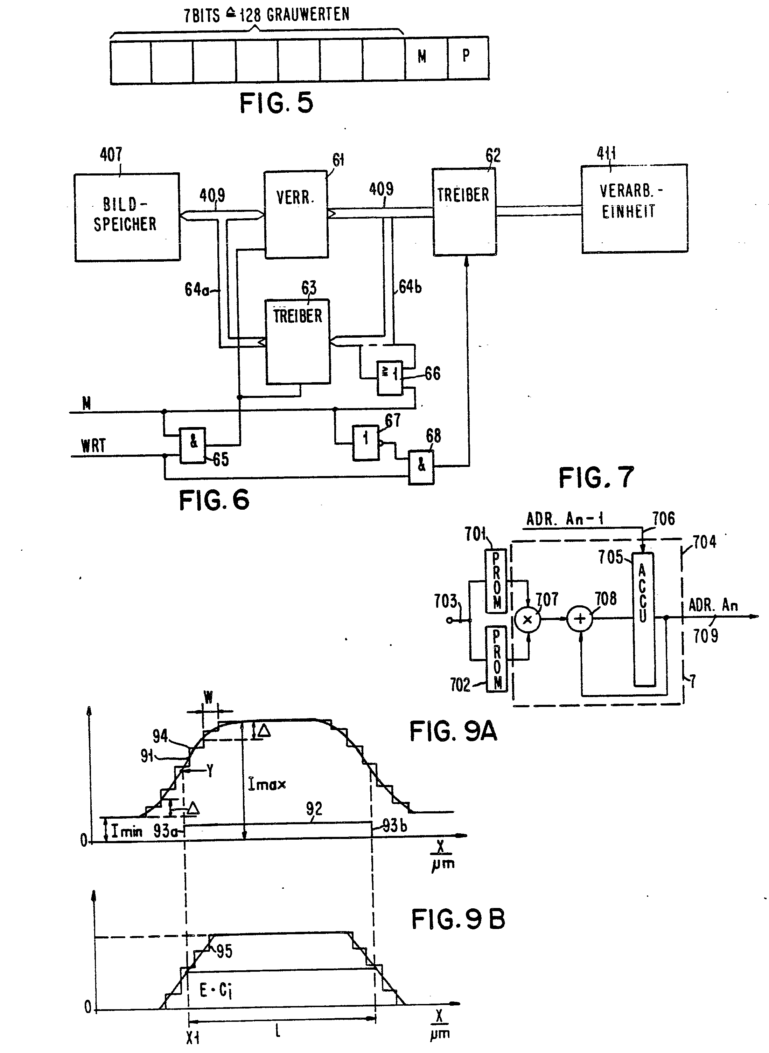

Das in der vorliegenden Erfindung vorgeschlagene Prüfverfahren ermöglicht je nach Ausgestaltung des Systems die lokale Prüfung alleine oder zusammen mit der Einbeziehung von Konstruktionsdaten. Im ersten Fall wird in dem gespeicherten Digitalbild des zu untersuchenden Musterabschnitts entsprechend Fig. 1 mit einem Suchvorgang systematisch gesucht, bis eine Kante auftritt ; im zweiten Fall wird mit Hilfe der Konstruktionsdaten der Punkt des Speichers adressiert (z. B. Punkt X), in dem der Grauwert des Ausgangspunkts einer Kante gespeichert ist. In beiden Fällen wird der auf die beschriebene Weise festgestellte Kantenpunkt als Ausgangspunkt für eine mäanderförmige Abtastung der Kante gewählt (Linienzug 8), indem die Speicheradressen berechnet werden, die den Bildpunkten auf diesem Linienzug entsprechen. Eine Schaltungsanordnung zur schnellen Ermittlung von Speicheradressen der Bildpunkte auf dieser Abtastspur wird später anhand von Fig. 7 erläutert.

Ist die Kante des Leiterzugs 2 an keiner Stelle gestört und weisen alle Kanten in eine der erlaubten Richtungen (z. B. waagerecht, senkrecht, unter 45° oder unter beliebige andere Winkel verlaufend), so wird bei der Kantenabtastung schließlich der Punkt Y erreicht, und die Abtastspur kann auf die Kante eines weiteren Leiterzugs gesetzt werden.

Die Einzelheiten des Verlaufs einer Abtastspur 22 längs einer Kante 21 sind in Fig. 2 dargestellt. Der nachfolgend beschriebene Algorithmus gilt für Kanten, sinngemäß aber auch für Linien oder dünne Leiterzüge, die dann bei der mäanderförmigen Abtastung in voller Breite überstrichen werden. Die einzelnen Bildelemente (die der minimalen Ortsauflösung des Bildes entsprechen) sind in Fig. 2 mit den Quadraten 20a, b, ... 21a, b ... usw. dargestellt. Die Abtastspur 22 verläuft senkrecht zur Kantenrichtung und umfaßt drei Bildelemente 20b bis 20d, deren Grauwert aus dem Bildspeicher ausgelesen und zur Bildung einer Summe $\Sigma$ verwendet wird. Beim Fortschreiten der Abtastspur in Kantenrichtung wird jeweils die Differenz von zwei aufeinanderfolgenden Summenwerten gebildet (z. B. $\Delta 1 = \Sigma 2 - \Sigma 1$). Liegt die Kante 21 genau senkrecht zur Abtastspur und weist sie keine lokalen Verzerrungen auf, so ist die Differenz $\Delta$ immer 0. Bei einer lokalen Veränderung der Kante (z. B. der Einbuchtung 23), die auch kleiner als 1 Bildelement sein kann, ändert sich dagegen die Differenz $\Delta$ auf einen Wert $\neq$ 0, der somit als Fehleranzeige verwendet werden kann. Eine Änderung der Kantenrichtung insgesamt, z. B. beim Knick 24 um den Winkel $\alpha$, wirkt sich so aus, daß aufeinanderfolgende Differenzwerte eine direkte Funktion der Änderung der Kantenrichtung darstellen.

Die Anzahl der senkrecht zur Kantenrichtung liegenden Bildpunkte, die zur Grauwertsumme beitragen, muß entsprechend dem jeweiligen Kantenverlauf in einem Muster gewählt werden. Die Umkehrpunkte der Abtastspur 22 (in den Bildelementen 20a, 21a, ... und 20e, 21e, ...) sollten außerhalb des Kantenbereichs liegen ; diese Punkte sind in Fig. 2 mj TH bezeichnet. Sie stellen die Bezugs- oder Schwellwerte für « Hell », bzw. « Dunkel » dar.

Fig. 3 zeigt die zur Grauwertsumme verwendeten Bildelemente bei Kanten, die unter 45° verlaufen. Um beliebig verlaufende Kanten mit diesem Differenzverfahren zu verfolgen, ist die geeignetste Grundrichtung (waagerecht, senkrecht, 45°) zu wählen und die damit errechnete Grauwertsumme durch Addition einer Konstante zu korrigieren. Zur Ermittlung der Summen $\Sigma$ längs des Abtastwegs 30 werden die Digitalwerte A und B oder C herangezogen.

Die außerhalb des Summiergebiets liegenden Bildpunkte im Abtastpfad sind wieder mit TH bezeichnet.

Neben der oben beschriebenen Ermittlung von Kantenfehlern, deren Ausdehnung in der Größenordnung eines Bildpunkts oder darunter liegt (sogenannte hochfrequente Störungen), können auch niederfrequente Störungen des Kantenverlaufs ermittelt werden, wenn die Differenz der Grauwertsummen nicht zwischen benachbarten Kantenpunkten, sondern aus weiter entfernt voneinander liegenden Kantenpunkten ermittelt wird.

Bei der Kantenverfolgung nach dem oben beschriebenen Abtastverfahren werden alle Fehler erkannt, die im Bereich der Abtastspur der Kante liegen, wie beispielsweise der Einschluß 10b in Fig. 1. Die Adressen dieser defekten Stellen können beispielsweise in eine Fehlerliste zur späteren Auswertung eingetragen werden.

Alle während der Kantenverfolgung durchlaufenden Punkte im Grauwertbild, das im Bildspeicher enthalten ist, werden markiert, indem ein Bit des dem Bildpunkt zugeordneten Digitalworts den Wert 1 erhält. Als Markierbit wird dabei vorzugsweise das niedrigstelligste Bit der Digitalzahl herangezogen, mit der die Grauwertstufe des zugeordneten Bildpunktes angezeigt wird. Da üblicherweise jedem Bildpunkt im Speicher ein Byte mit 8 Bits zugeordnet wird, verringert sich die Anzahl der darstellbaren Graustufen durch Einführung des Merkbits von 256 auf 128 ; damit stehen aber immer noch ausreichend viele Grauwerte zu einer genauen Bilddarstellung zur Verfügung. Fig. 5 zeigt das Format eines derartigen Speicherworts mit Markierbit M und Paritätsbit P.

In dem ersten Verarbeitungsschritt des erfindungsgemäßen Prüfverfahrens werden nun alle Kanten des Bildausschnittes 1 in der oben beschriebenen Weise abgetastet, so daß danach in den nicht markierten Bereichen nur noch Grauwertstufen auftreten dürfen, die einem hellen Bereich (Leiterzüge) oder einem dunklen Bereich (Isolierplatte) entsprechen. Dabei können auch schmale Leiterzüge mit einer mäanderförmigen Abtastspur abgetastet werden.

Der zweite Verarbeitungsschritt nach dem erfindungsgemäßen Verfahren besteht nun darin, daß die während des ersten Schrittes nicht markierten Bereiche des Bildspeichers sehr rasch sequentiell daraufhin überprüft werden, ob andere Werte als hell oder dunkel vorliegen (Bei dieser Prüfung wird der Speicher beispielsweise sequentiell adressiert). Ist dies der Fall, so handelt es sich bei den entsprechenden Bildpunkten um fehlerhafte Stellen der Leiterplatte (z. B. 10a oder 11c). Da selbst in komplizierten Mustern der auf Kanten- oder Linienbereiche entfallende Anteil relativ klein ist, kann durch die Aussonderung (Filterung) der Kanten- oder Linienbereiche im ersten Verfahrensschritt der Geschwindigkeitsvorteil, der sich beim zweiten Verfahrensschritt ergibt, voll zum Tragen kommen, so daß insgesamt die Prüfung eines Bildes oder eines Bildausschnitts sehr viel weniger Zeit erfordert als beispielsweise bei der rasterförmig erfolgenden Untersuchung aller Bildpunkte, bei der jeder Punkt auch daraufhin überprüft werden muß, ob eine Kante oder Linie vorliegt oder nicht.

Die von dem zweistufigen Vergleichsverfahren ermöglichte hohe Verarbeitungsgeschwindigkeit läßt sich durch den Einsatz eines digitalen Verarbeitungssystems weiter steigern, das in besonderer Weise auf die Bedürfnisse dieses Verfahrens angepaßt ist. Ein Schwerpunkt der Einrichtung zur Durchführung des Verfahrens liegt in deren Speichersystem, das sehr schnelle Auslese- und Einschreibvorgänge ermöglicht.

Fig. 4 zeigt ein Blockdiagramm einer derartigen Einrichtung mit einem X-Y-Tisch 400, auf dem eine zu untersuchende Leiterplatte 401 liegt, die über ein optisches System 402 insgesamt oder abschnittweise in eine Fernsehkamera 403 abgebildet wird. Vorzugsweise wird eine Fernsehmeßkamera verwendet, aus der zur Erhöhung der Genauigkeit ein in der Mitte der Aufnahmefläche liegender quadratischer Bildbereich sehr geringer Verzerrung mit 512 × 512 Bildpunkten entnommen wird. Das Ausgangssignal der Fernsehkamera wird einer Einrichtung 405 zur Bildanalyse zugeführt. In dieser Einrichtung erzeugt ein Analog/Digital-Umsetzer 406 ein Digitalbild, dessen einzelne Bildpunkte einem von 128 Grauwerten zugeordnet werden. Das digitalisierte Bild wird über eine Sammelleitung 408 in einem Bildspeicher 407 abgelegt, der über ein weiteres Sammelleitungssystem 409a, 409b mit einem Mikroprozessor 410 und einer Verarbeitungseinheit 411 verbunden ist, die Schaltungen zur schnellen Verarbeitung der im Speicher 407 enthaltenen Bildinformation enthält. Der Mikroprozessor 410 enthält Steuerleitungen 412, 413 zur Verarbeitungseinheit 411 und zum Analog/Digital-Umsetzer 406 und ist über eine weitere Leitung 414 mit einem Rechner 415 verbunden, der die gesamte Einrichtung steuert und dazu Operatorbefehle über ein Terminal 416 empfängt. Ein Monitor 404 ist an den Digital/Analog-Umsetzer 406 angeschlossen und ermöglicht es, das im Speicher 407 enthaltene verarbeitete Bild anzuzeigen.

Die Speichereinheit 407 enthält drei Speicherblöcke 420a, 420b, 420c, die jeweils ein vollständiges digitalisiertes Bild mit 512 × 512 Bildelementen aufnehmen und somit eine Speicherkapazität von 256 Kilobyte aufweisen. Ein Speicherblock, z. B. 420a, ist über eine 8-Bit Sammelleitung 408 mit dem A/D bzw. D/A-Umsetzer 406 verbunden und enthält das empfangene oder auf dem Monitor 404 anzuzeigende Bild. Jeder der Speicherblöcke 420 a, b, c kann wahlweise mit einer der drei Sammelleitungen durch Betätigen einer der Schalter 421 mit einer beliebigen 8-Bit Sammelleitung 490a, 409b, 409c verbunden werden. Die Schalter 421 bestehen aus bekannten Multiplexschaltungen, die fest mit jeder der Sammelleitungen 409a bis c verbunden sind und sowohl die Daten als auch die Steuerleitungen einer jeden Sammelleitung 409 wahlweise mit dem ihnen zugeordneten Speicherblock verbinden. Die Steuerung der Schaltung 421 erfolgt durch den Mikroprozessor 410. Durch die schaltbaren Sammelleitungen 409a bis 409c ist es möglich, zwischen jedem der Speicherblöcke 420 und dem Mikroprozessor 410 oder der Verarbeitungseinheit 411 eine unabhängige Speicheroperation durchzuführen. Beispielsweise können zwei der Speicherblöcke Bilddaten zur Verarbeitung abgeben (zur Addition oder Subtraktion der beiden Bilder), während in den dritten Speicherblock die Resultate dieser Verarbeitung eingeschrieben werden. Da bei der Verarbeitung eines jeden Bildpunkts die Bilddaten ausgelesen und danach wieder eingespeichert werden müssen, ergibt sich durch den simultanen Betrieb dreier Speichereinheiten eine beträchtliche Erhöhung der Verarbeitungsgeschwindigkeit.

In Fig. 6 ist das Blockschaltbild einer Vorrichtung angegeben, die zwischen die Verarbeitungseinheit 411 und den Bildspeicher 407 geschaltet ist und mit der im zweiten Verfahrensschritt die Verarbeitung des Markierbits beschleunigt wird. Jedes im zweiten Verfahrensschritt über eine der Sammelleitungen 409 ausgelesene Bildelement wird in einer Verriegelungsschaltung 61 zwischengespeichert ; stellt die Verarbeitungseinheit 411 fest, daß in diesem Bildelement das Markierungsbit M angesetzt ist, gibt sie einen Schreibbefehl WRT ab, der zusammen mit dem invertierten Signal für das Markierungsbit im UND-Glied 68 ein Sperrsignal für den Treiber 62 erzeugt, der sonst Daten von der Verarbeitungseinheit 411 zum Speicher 407 gibt. Stattdessen aktiviert das Schreibsignal WRT zusammen mit dem Signal für das Markierungsbit in UND-Glied 65 einen Treiber 63 (Tristate-Treiber), der die in der Verriegelungsschaltung 61 gespeicherten Daten über die 8-Bit Sammelleitungen 64a und 64b direkt in den Bildspeicher 407 zurückgibt. Die bereits bearbeiteten Bildpunkte brauchen somit in der Verarbeitungseinheit 411 nicht mehr zwischengespeichert und von dort ausgelesen werden, so daß bei jedem dieser Bildelemente einige sonst erforderliche Instruktionen entfallen. Das erstmalige Setzen eines Markierbits erfolgt mit dem Markiersignal M in ODER-Glied 66.

Fig. 7 zeigt eine Schaltung zur schnellen Adresserzeugung, z. B. für die Kantenverfolgung, wie sie anhand von Fig. 2 erläutert wurde. Dort ist es wichtig, die Adressen von Bildpunkten mit großer Geschwindigkeit zu ermitteln, die in der Nachbarschaft eines ausgesuchten Bildpunktes liegen, wenn in horizontaler, vertikaler oder diagonaler Richtung fortgeschritten wird. In Bildspeichern mit großer Kapazität, beispielsweise 256 K-Bytes sind beispielsweise 18 Bitadressen erforderlich, so daß auch bei

5

Adressen benachbarter Bildpunkte eine Änderung in vielen Bitstellen der Adresse erforderlich ist; Mikroprozessoren mit ihrer relativ geringen Anzahl von Adressleitungen (z. B. 8), benötigen zur Adressgenerierung für Nachbarbildpunkte daher mehrere Zyklen. In der Schaltung von Fig. 7 wird zur Beschleunigung der Adressberechnung die Adresse $A_n$ eines Bildpunkts n in der Nachbarschaft eines Bildpunkts n − 1 in folgender Weise als Produkt zweier Terme dargestellt:

$$A_n = A_{n-1} + X \cdot Y$$

wobei X und Y die Ausgangssignale von zwei progammierbaren Festwertspeichern 701, 702 sind, die ihrerseits von der Verarbeitungseinheit 411 oder dem Mikroprozessor 410 über dreiadrige Steuerleitungen 703 Eingangssignale erhalten, die in codierter Form eines von acht Nachbarelementen bezeichnen. Die PROM-Ausgangssignale X und Y sind dann beispielsweise in einem 512 × 512 Bildspeicher:

| X | Y | X·Y | angeforderte Adress-Richtung | |
|---|---|---|---|---|
| 1 | 1 | 1 | $0^{\circ}$ = +X | |
| 1 | −1 | −1 | $180^{\circ}$ = −X | |
| 16 | 32 | 512 | $90^{\circ}$ = +Y | |
| −16 | 32 | −512 | $180^{\circ}$ = −Y | |
| 7 | 73 | 511 | $135^{\circ}$ | |
| −7 | 73 | −511 | $315^{\circ}$ | Diagonale |
| 9 | 57 | 513 | $45^{\circ}$ | |
| −9 | 57 | −513 | $225^{\circ}$ | |

Die PROM-Ausgangssignale werden in einem Multiplizierglied 707 multipliziert und in einem Addierglied 708 mit der Adresse $A_{n-1}$ des Bildpunkts n − 1, die in einem Akkumulatorregister 705 gespeichert ist, addiert. Die arithmetischen Einheiten 707, 708 und der Akkumulator 705 sind beispielsweise als integrierte Schaltung 704 realisiert. Die Verbindungsleitungen zwischen den PROM's 701, 702 und dem Multiplizierglied 707 sind 8-adrig ausgeführt, die mit ACCN 705 verbundene Adreßleitungen 706, 709 sind 18-adrig.

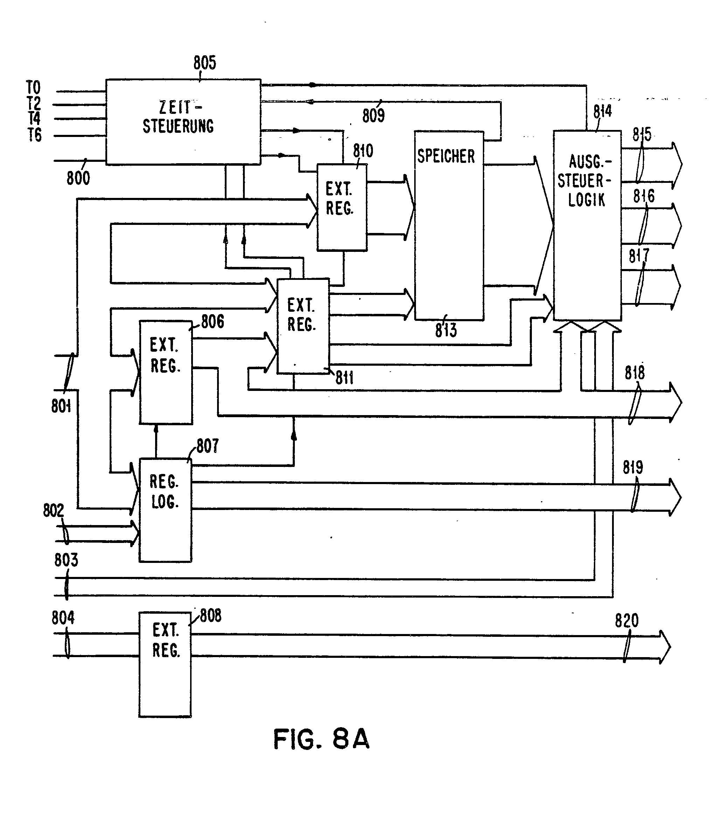

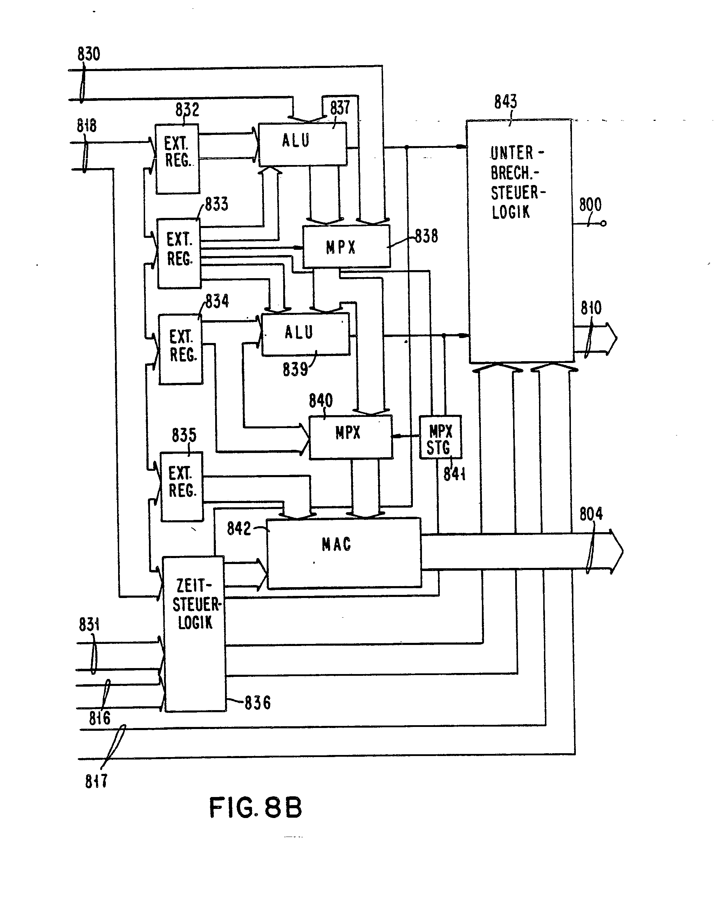

Die Fig. 8A, 8B zeigen in schematischer Weise den Aufbau der Verarbeitungseinheit 411, die aus zwei Teilen besteht:

einer in Fig. 8A dargestellten Steuerschaltung (Sequenzer) und

einer in die Steuerschaltung einsteckbaren Schaltkarte, die auf die jeweilige von der Verarbeitungseinheit 411 durchzuführende Funktion abgestimmt ist. Fig. 8B zeigt als Beispiel das Blockschaltbild für eine derartige steckbare Karte.

Der Sequenzer nach Fig. 8A steuert die Funktionen der angeschlossenen Steckkarte und wird seinerseits vom Mikroprozessor gesteuert. Er enthält eine Reihe von Registern (806, 808, 810, 811), die direkt vom Mikroprozessor adressiert werden können (über Adreßbus 802) und Daten von Sammelleitungen (z. B. Bus 801) aufnehmen oder an Sammelleitungen (z. B. Bus 820) abgeben können, die mit dem Mikroprozessor und anderen Komponenten verbunden sind. Eine Registersteuerlogik 807 ist zur Steuerung des Datenverkehrs zwischen diesen Registern und dem Mikroprozessor vorgesehen. Diese sogenannten externen Register des Mikroprozessors können von dessen Instruktionen direkt angesprochen werden. Eines der Register 810 dient als Adreßregister für einen Schreib/Lesespeicher 813 und ist als Zähler ausgebildet, um selbständig nacheinander mehrere Speicheradressen anzusteuern. In dem Speicher 813 wird die Steuerinformation abgelegt, die zur Durchführung einer bestimmten Funktion an die Steuereingänge der steckbaren Karte angelegt werden muß; eine bestimmte Funktionssequenz wird aufgerufen, wenn der Inhalt des Zählers 810 vom Mikroprozessor gesetzt wird und die Zeitsteuerung 805 durch den Inhalt des ebenfalls vom Mikroprozessor geladenen Registers 811 in Gang gesetzt ist. Die Ausgangssignale des Speichers 813 werden über eine Ausgangssteuerlogik 814 abgegeben. Die Steuersignale für die steckbare Karte erscheinen dann auf einem Bus 816, Steuersignale für den Speicher 407 auf einem Bus 815 und Diagnostiksignale auf einem Bus 817. Die durch den Inhalt des Zählerregisters 810 veranlaßte Schrittfolge wird beendet, wenn die letzte Steuerinformation aus dem Speicher 813 ausgelesen wird, in der ein bestimmtes Steuerbit (z. B. Bit 0) über Leitung 809 die Zeitsteuerung 805 stoppt, die ihrerseits das Fortschalten des Zählerregisters 810 beendet. Die Zeitsteuerung 805 läuft synchron mit den Maschinentakten T0 bis T6 des Mikroprozessors ; sie kann auch über ein externes Unterbrechungssignal auf Leitung 800 gestoppt werden, wenn z. B. bei der Verarbeitung der Bilddaten ein Fehler wie « Überschreiten eines Schwellwerts » aufgetreten ist.

Die vom Mikroprozessor in das externe Register 806 gegebene Steuerinformation kann über Bus 818 an die steckbare Karte weitergegeben werden. Ergebnisse, die von der steckbaren Karte über Bus 804 an die Steuereinheit zurückgegeben werden, gelangen über das externe Register 808 und den Bus 820 zum Mikroprozessor. Synchronisiersignale für den Speicherbetrieb werden über Bus 803 an die Ausgangssteuerlogik 814 gegeben. Bus 819 ist mit weiteren externen Registern des Mikroprozessors verbunden.

Mit der Steuereinheit nach Fig. 8A können durch geeignete Programmierung des Speichers 813 und durch Eingabe entsprechender Werte in die externen Register beliebige Schrittfolgen definiert werden, die auch komplizierte Verarbeitungsvorgänge in den angeschlossenen Steckkarten steuern können.

In Fig. 8B ist ein Beispiel für eine Steckkarte dargestellt, mit der die Grauwerte eines digitalisierten Bilds daraufhin untersucht werden, ob sie innerhalb vorgegebener Schwellwerte liegen ; eine weitere Anwendungsmöglichkeit dieser Karte besteht in der genauen Bestimmung von Linienbreiten in digitalisierten Bildern. In Fig. 8B tragen die zu Fig. 8A gleichen Busse zur Verbindung der Steckkarte mit der Steuereinheit dieselben Bezugszeichen.

Die in Fig. 8B schematisch dargestellte Steckkarte ist über einen Bus 830 mit der Speichereinheit 407 verbunden, über den sie zu verarbeitende Bildpunktinformation empfängt und als Operanden in ein erstes Rechenwerk 837 oder über einen Multiplexer 838 in ein zweites Rechenwerk 839 gibt. An den aus der Steuereinheit zugeführten Steuerdatenbus 818 sind mehrere externe Register 832 bis 835 angeschlossen, von denen die Register 832 und 834 mit den Rechenwerken 837 bzw. 839 verbunden sind. Register 833 ist über Steuerleitungen mit den Rechenwerken 837 und 839 und dem Multiplexer 838 verbunden. Register 835 ist mit einem Schaltkreis 842 verbunden (Multiplizierer-Addierer MAC), der zwei zugeführte Werte (X, Y) multipliziert und die nacheinander ermittelten Ergebnisse addiert. Diese Schaltung 842 ist beispielsweise als integrierte Schaltung erhältlich ; in der Schaltkarte nach Fig. 8B ist der zweite Anschluß mit dem Multiplexer 840 verbunden, der seinerseits mit dem Ausgang des Rechenwerks 839 und dem Ausgang des ersten Multiplexers 838 verbunden ist. Multiplexer 840 ist außerdem mit dem Register 834 verbunden. Die Rechenwerke 837 und 839 geben Statusinformation über das Ergebnis der Rechnung an eine Unterbrechungssteuerlogik 843 ab, mit denen die Unterbrechungsleitung 800 aktiviert werden kann. An die Unterbrechungssteuerlogik 843 ist außerdem der Diagnosebus 810 angeschlossen. Eine Zeitsteuerlogik 836 empfängt die Steuersignale der Steuereinheit über Bus 816 und kann über Bus 831 außerdem mit Speicherdaten geladen werden. Die Ergebnisse des Multiplizierer-Addierers 842 können über Bus 804 an die Steuereinheit gegeben werden. Die Auswahlsignale für die Multiplexer 838, 840 werden vom Register 833 bzw. der MPX-Steuerung 841 geliefert.

Zur Untersuchung, ob ein aus dem Speicher 407 ausgelesener digitaler Bildwert innerhalb vorgegebener Schwellwertgrenzen liegt, wird der Wert der unteren Schwelle $TH_{min}$ in Register 832 eingelesen und der Wert der oberen Schwelle $TH_{max}$ in Register 834. Die Rechenwerke 837 und 839 vergleichen dann den Wert des über Bus 830 eingelesenen Binärworts und geben bei Überschreiten der Schwellwerte ein Steuersignal an die Unterbrechungssteuerlogik 843.

In einer zweiten Betriebsart der Schaltkarte nach Fig. 8B werden die Bildpunkte, die innerhalb der zulässigen Grauwerte liegen, im Multiplizierer-Addierer 842 mit einer Normierungskonstante multipliziert, die im Register 835 gespeichert ist. Die Verarbeitung aller Bildpunkte, die beim Abtasten einer Leiterzugbahn entstehen, ergibt dann ein Maß für die genaue Leiterzugbreite, wie im folgenden anhand von Fig. 9 erläutert wird.

Fig. 9A zeigt das Profil 91 einer Leiterbahn, das erhalten wird, wenn ein Photodetektor über die Leiterbahn 92 mit Kanten 93a und 93b geführt wird. Nach der Digitalisierung erscheint das Profil als Stufenkurve 4 ; die Breite w jeder Stufe entspricht der seitlichen Ausdehnung (Breite) eines Bildelements und stellt die Unsicherheit dar, mit der die genaue Lage einer Kante, z. B. $X_1$ bestimmt werden kann. Die Kantenlage wird beispielsweise als Punkt Y definiert, bei dem die Intensität des Profils um 50 % gegenüber dem Grundsignal $I_{min}$ angestiegen ist. Dieser Digitalisierungsfehler tritt in allen Binärdarstellungen von Bildern oder Intensitätsprofilen auf, bei denen die Bildelemente durch Vergleich ihres Grauwerts mit einem festen Schwellwert TH entweder schwarz oder weiß ausgesteuert werden.

Zur Erhöhung der Meßauflösung unter die Breite eines Bildelements wird in der anhand von Fig. 8B beschriebenen Schaltkarte eine Integration aller Grauwerte längs des Profils 91 durchgeführt, nachdem diese Grauwerte bezüglich des Maximalsignals $I_{max}$ normiert wurden. Um Rauscheinflüsse zu unterdrücken, werden nur solche Grauwerte bei der Integration berücksichtigt, deren Intensität größer $I_{min} + \Delta$ und kleiner als $I_{max} - \Delta$ sind, wobei $\Delta$ der maximale Beitrag des Rauschens im Photodetektorausgangssignal ist. Das Ergebnis der Integration stellt die Fläche unter dem normierten trapezförmigen Kantenprofil 95 in Fig. 9B dar. Die genaue Lage $X_1$ wird dann mit Hilfe der Trapezregel aus einem Rechteck mit Seitelänge 1 berechnet, das dieselbe Oberfläche aufweist wie das Trapez.

Zur Durchführung der Berechnung von Leiterbahnbreiten in der Schaltkarte nach Fig. 8B werden die Register 832 und 834 mit den Werte $I_{min} + \Delta$ und $I_{max} - \Delta$ geladen ; die Normalisierungskonstante $I_{max}$ wird als Kehrwert im Register 835 gespeichert, gegebenenfalls mit einem konstanten Multiplikationsfaktor, um Werte kleiner 1 während der Normierung zu vermeiden.

Grauwerte, die über Bus 830 zugeführt werden und innerhalb der Grenzen $I_{min} + \Delta$, $I_{max} - \Delta$ liegen,

werden direkt dem Multiplizierer-Addierer 842 zugeführt; kleinere Werte als $I_{min} + \Delta$ werden unterdrückt, größere Werte auf den Wert $I_{max} - \Delta$ herabgesetzt. Die beiden letztgenannten Funktionen werden von der Steuereinheit nach Fig. 8A durchgeführt, die vom Mikroprozessor aktiviert wird, wenn auf Leitung 800 ein Unterbrechungssignal aufgetreten ist.

Die Verarbeitungseinheit 411 wird für die Verarbeitung eines jeden einzelnen Bildpunkts durch einen Befehl des angeschlossenen Mikroprozessors aktiviert; verschiedene Bildpunkte können also verschiedenen Verarbeitungsschritten unterworfen werden. Die Zykluszeit des Mikroprozessors und der Zeitbedarf der Verarbeitungseinheit 411 für eine Operation werden zweckmäßigerweise so ausgelegt, daß sie zasammen kleiner oder höchstens gleich der Zugriffszeit der Speichereinheit 407 sind, so daß die volle Geschwindigkeit des Speicherzugriffs zur Verfügung steht. Eine Unterbrechung des hohen Datenflusses vom Bildspeicher zur Verarbeitungseinheit 411 tritt dann nur auf, wenn diese Bedingungen feststellt, die vom Mikroprozessor bearbeitet werden müssen und dazu ein Unterbrechungssignal abgibt.

Die Verarbeitungseinheit 411 mit einer universell verwendbaren Steuereinheit nach Fig. 8A und individuell auf das Verarbeitungsproblem zugeschnittenen, in die Steuereinheit einstreckbaren, Schaltkarten ermöglicht es, eine Vielzahl von Bildverabeitungsfunktionen mit hoher Geschwindigkeit durchzuführen.

## Patentansprüche

1. Verfahren zur automatischen optischen Inspektion einer digitalisierten, im wesentlichen zweidimensionalen und in einem Bildspeicher abgelegten Bildvorlage, bei dem in einem ersten Verarbeitungsschritt die Kanten der Bildelemente ermittelt und im Bildspeicher (407) markiert werden, dadurch gekennzeichnet, daß im ersten Verarbeitungsschritt ausschließlich Kanten oder Linien (2 ; Übergang zwischen zwei optisch verschiedenen Bereichen) der Länge nach abgetastet und im Bildspeicher (407) markiert werden und daß in einem zweiten Verfahrensschritt die nicht markierten Gebiete der Bildvorlage punktweise auf das Vorliegen von nur außerhalb von Kantengebieten erlaubten Helligkeitswerten geprüft werden.

2. Verfahren nach Anspruch 1, dadurch gekennzeichnet, daß der Bildspeicher in einer Weise adressiert wird, die eine mäanderförmige Abtastungsspur der Kante ergibt.

3. Verfahren nach Anspruch 2, dadurch gekennzeichnet, daß digitale Grauwerte der senkrecht zur Kante (2) abgetasteten Bildpunkte (20) addiert und die Summen ($\Sigma$) paarweise subtrahiert werden.

4. Verfahren nach Anspruch 1 oder 2, dadurch gekennzeichnet, daß die Markierung der Kantengebiete durch ein Bit (M ; Fig. 5) in dem Speicherwort erfolgt, das einem Bildelement zugeordnet ist.

5. Einrichtung zur Durchführung des Verfahrens nach einem der Ansprüche 1 bis 3, dadurch gekennzeichnet, daß an den Ausgang eines Bildspeichers (407) eine Verriegelungsschaltung (61) zur Aufnahme ausgelesener Speicherinformation angeschlossen ist, um markierte Speicherelemente ohne Speicherbefehle der Verarbeitungseinheit (411) direkt in den Speicher zurückzuschreiben.

6. Einrichtung nach Anspruch 5, dadurch gekennzeichnet, daß die Speichereinheit (407) aus mehreren Speichermoduln (420a, b, c) besteht, die über schaltbare Busse (409a, b, c) mit einem Mikroprozessor (410) und einer Verarbeitungseinheit (411) verbunden sind.

7. Einrichtung nach Anspruch 5 oder 6 zur Durchführung des Verfahrens nach Anspruch 3, dadurch gekennzeichnet, daß zur Berechnung der Adressen von Bildpunkten in der Umgebung eines ausgewählten Bildpunktes ein Akkumulatorregister (705) zur Aufnahme der Adresse des ausgesuchten Bildpunktes vorgesehen ist, dem die multiplikativ verknüpften Ausgänge von zwei durch Adreßsignale (703) angesteuerten programmierbaren Festwertspeichern (701, 702) additiv zugeführt werden.

8. Einrichtung nach einem der Ansprüche 5 bis 7, dadurch gekennzeichnet, daß eine Verarbeitungseinheit (411) zur Durchführung von Bildpunktoperation aus einer durch Instruktionen eines Mikroprozessors (410) gesteuerten Steuereinheit (Fig. 8A) besteht, mit der für die durchzuführende Operation charakteristische Schrittfolge-Steuersignale an eine in die Steuereinheit steckbare Schaltkarte (Fig. 8B) abgegeben werden, die Schaltungen zur Durchführung der Operation enthält.

9. Einrichtung nach Anspruch 8, dadurch gekennzeichnet, daß eine Schaltkarte verwendet wird, die zur Breitenbestimmung von Leiterzügen die bei deren Abtastung erzeugten Grauwerte normiert und addiert.

10. Einrichtung nach einem der Ansprüche 5 bis 9, dadurch gekennzeichnet, daß der Mikroprozessor (410) zur Durchführung der Bildverarbeitungsoperationen von einem Rechner (415) gesteuert wird, der mit einem Endgerät (416) zur Durchführung von Eingabe-/Ausgabe-Operationen verbunden ist.

## Claims

1. Method for the automatic optical inspection of a digitalized, substantially two-dimensional image stored in an image storage, wherein in a first processing step, the edges of the picture elements are determined and marked in an image storage (407), characterized in that in the first processing step, only edges or lines (2 ; transition between two optically different regions) are scanned over their entire length

# 0 095 517

and marked in the image storage (407), and that in a second processing step, the non-marked regions of the image are tested picture element by picture element for the presence of brightness values permissible only outside edge regions.

2. Method according to claim 1, characterized in that the image storage is adressed such that the edge is meander-scanned.

3. Method according to claim 2, characterized in that digital grey values of the picture elements (20) scanned perpendicularly to the edge (2), are added and the sums ($\Sigma$) are subtracted in pairs.

4. Method according to claim 1 or 2, characterized in that the edge regions are marked by a bit (M ; Fig. 5) in the stored word associated with a picture element.

5. Apparatus for implementing the method according to any one of the claims 1 to 3, characterized in that latch (61), accommodating read storage information, is connected to the output of an image storage (407) for writing back marked storage elements direct into storage without storage instructions from the processing unit (411).

6. Apparatus according to claim 5, characterized in that the storage unit (407) consists of several storage modules (420a, b, c) connected by switchable busses (409a, b, c) to a microprocessor (410) and a processing unit (411).

7. Apparatus according to claim 5 or 6 for implementing the method according to claim 3, characterized in that for computing the addresses of picture elements in the vicinity of a selected picture element, an accumulator register (705) is provided for accommodating the address of the selected picture element, to which the multiplicatively linked outputs of two programmable read-only storages (701, 702), controlled by address signals (703), are applied by addition.

8. Apparatus according to any one of the claims 5 to 7, characterized in that a processing unit (411) for implementing picture element operations consists of a control unit (Fig. 8A) controlled by instructions of a microprocessor (410) and emitting sequence control signals, characteristic of the operation to be implemented, to a circuit card (Fig. 8B) pluggable to the control unit and comprising circuits for implementing the operation.

9. Apparatus according to claim 8, characterized in that a circuit card is used which for determining the width of conductors normalizes and adds the grey values generated during conductor scanning.

10. Apparatus according to any one of the claims 5 to 9, characterized in that the microprocessor (410) for implementing the image processing operations is controlled by a computer (415) connected to a terminal (416) for implementing input/output operations.


## Revendications

1. Procédé pour réaliser le contrôle optique automatique d'un modèle d'image mis sous forme numérique, essentiellement bidimensionnel et mémorisé dans une mémoire d'images, et selon lequel lors d'une première phase opératoire, on détermine les bords de l'élément d'image et on les marque dans la mémoire d'images (407), caractérisé en ce que, lors de la première phase opératoire, on explore exclusivement des bords ou des traits (2 ; jonction entre deux zones différentes du point de vue optique) sur leur longueur et on les marque dans la mémoire d'images (407) et qu'au cours d'une seconde phase opératoire, on contrôle de façon ponctuelle si les zones non marquées du modèle d'image comporte des valeurs de luminosité autorisées uniquement à l'extérieur des zones des bords.

2. Procédé selon la revendication 1, caractérisé en ce que la mémoire d'images est adressée d'une manière qui fournit une trace d'exploration sinueuse du bord.

3. Procédé selon la revendication 2, caractérisé en ce que les valeurs numériques de gris des points d'image (20) explorés perpendiculairement au bord (2) sont additionnées et que les sommes ($\Sigma$) sont soustraites par couples.

4. Procédé selon la revendication 1 ou 2, caractérisé en ce que le marquage des zones des bords est réalisé à l'aide d'un bit (M ; figure 5) dans le mot de mémoire qui est associé à un élément d'image.

5. Dispositif pour la mise en œuvre du procédé selon l'une des revendications 1 à 3, caractérisé en ce qu'à la sortie d'une mémoire d'images (407) se trouve raccordé un circuit de verrouillage (61) servant à recevoir une information de mémoire lue, afin d'enregistrer en retour directement dans la mémoire, les éléments de mémoire marqués, sans instruction de mémorisation de la part de l'unité de traitement (411).

6. Dispositif selon la revendication 5, caractérisé en ce que l'unité de mémoire (407) est constituée par plusieurs modules de mémoire (420a, b, c), qui sont reliés par l'intermédiaire de bus commutables (409a, b, c) à un microprocesseur (410) et à une unité de traitement (411).

7. Dispositif selon la revendication 5 ou 6, pour la mise en œuvre du procédé selon la revendication 3, caractérisé en ce que, pour le calcul des adresses de points d'image dans l'environnement d'un point d'image sélectionné, il est prévu un registre accumulateur (705) servant à enregistrer l'adresse du point d'image recherché et auquel sont envoyés de façon additive, les signaux de sortie, combinés selon un mode multiplicatif, de deux mémoires mortes programmables (701, 702) commandées par des signaux d'adresses (703).

8. Dispositif selon l'une des revendications 5 à 7, caractérisé en ce qu'une unité de traitement (411) pour la mise en œuvre d'opérations sur des points d'image est constituée par une unité de commande

9

(figure 8A) commandée par des instructions d'un microprocesseur (410) et à l'aide de laquelle des signaux de commande de séquences pas à pas, qui sont caractéristiques pour l'opération devant être exécutée, sont délivrés à une carte à circuit imprimé (figure 8B) enfichables dans l'unité de commande et qui contient des circuits pour l'exécution de l'opération.

9. Dispositif selon la revendication 8, caractérisé en ce qu'on utilise une carte à circuits imprimés qui, pour la détermination de la largeur de voies conductrices, normalise et additionne les valeurs de gris produites lors de l'exploration de ces voies conductrices.

10. Dispositif selon l'une des revendications 5 à 9, caractérisé en ce que le microprocesseur (410) est commandé, pour l'exécution des opérations de traitement des images, par un calculateur (415) qui est relié à un terminal (416) pour l'exécution d'opérations d'entrée/sortie.

# FIG.1

# FIG.2

# FIG.3

# FIG.4

7BITS ≙ 128 GRAUWERTEN

| | | | | | | | M | P |

FIG. 5

FIG. 6

FIG. 7

FIG. 9A

FIG. 9 B

FIG. 8A

FIG. 8B

4